# EUROPÄISCHE PATENTSCHRIFT

(11) **EP 4 166 962 B1**
(45) Veröffentlichungstag und Bekanntmachung des Hinweises auf die Patenterteilung: **19.06.2024**
(21) Anmeldenummer: 21202939.1
(22) Anmeldetag: 15.10.2021
(51) Int. Cl.: G01R 31/3835, G01R 31/396, G01R 31/28

(54) **ELEKTRISCHER ENERGIESPEICHER**
ELECTRICAL ENERGY STORAGE DEVICE
ACCUMULATEUR D'ÉNERGIE ÉLECTRIQUE

(43) Veröffentlichungstag der Anmeldung: 19.04.2023
(73) Patentinhaber: Andreas Stihl AG & Co. KG, 71336 Waiblingen (DE)
(72) Erfinder: Sämann, Christian, 70372 Stuttgart (DE)
(74) Vertreter: Patentanwälte Ruff, Wilhelm, Beier, Dauster & Partner mbB

(56) Entgegenhaltungen:
- DE-A1-102007 049 528
- JP-A- 2014 171 323
- US-A1- 2017 219 658
- US-A1- 2021 265 671

## Beschreibung

Der Erfindung liegt die Aufgabe zugrunde, einen elektrischen Energiespeicher zur Verfügung zu stellen, der eine möglichst hohe Betriebssicherheit aufweist.

Der elektrische Energiespeicher ist insbesondere zur Verwendung mit einem handgetragenen Elektrowerkzeug, vorgesehen, wie beispielsweise einer Kettensäge, einer Heckenschere, einem Laubbläser oder dergleichen.

Der elektrische Energiespeicher weist herkömmlich eine Reihenschaltung einer Anzahl n von wiederaufladbaren Energiespeicherzellen auf, beispielsweise in Form von Akkumulatoren bzw. elektrochemischen Zellen. Die Anzahl n kann beispielsweise zwischen 2 und 40 betragen. Eine der Energiespeicherzellen ist mit einem Bezugspotential verbunden.

Der elektrische Energiespeicher weist weiter eine Reihenschaltung einer Anzahl n von Messwiderständen auf.

Der elektrische Energiespeicher weist weiter eine Anzahl n von ansteuerbaren Mess-Schaltmitteln auf, beispielsweise in Form von Transistoren. Solche elektrische Energiespeicher sind in US 2021/265671 A1, US 2017/219658 A1, DE 10 2007 049528 A1 und JP 2014 171323 A, zu sehen.

Zwischen die Reihenschaltung bestehend aus der Anzahl n von Energiespeicherzellen und die Reihenschaltung bestehend aus der Anzahl n von Messwiderständen ist ein erstes der Anzahl n von Mess-Schaltmitteln eingeschleift ist. Mit anderen Worten werden die Reihenschaltungen mittels des ersten Messschaltmittels an ihrem oberen Ende elektrisch verbunden.

Zwischen Verbindungsknoten von benachbarten Energiespeicherzellen und Verbindungsnoten von benachbarten Messwiderständen ist ein jeweils zugehöriges der Mess-Schaltmittel eingeschleift.

Der elektrische Energiespeicher weist weiter ein Symmetrier-Schaltmittel auf, beispielsweise in Form eines Transistors, das zwischen einen der Anzahl n von Messwiderständen und das Bezugspotential eingeschleift ist.

Der elektrische Energiespeicher weist weiter eine Messeinheit auf, beispielsweise in Form eines Mikrocontrollers, die bzw. der eine an einem der Anzahl n von Messwiderständen abfallende Spannung misst.

Der elektrische Energiespeicher weist weiter eine Steuereinheit auf, beispielsweise in Form eines Mikrocontrollers, die bzw. der dazu ausgebildet ist, die Mess-Schaltmittel und das Symmetrier-Schaltmittel anzusteuern, in Abhängigkeit von einem Schaltzustand der Mess-Schaltmittel und des Symmetrier-Schaltmittels und der mittels der Messeinheit gemessenen Spannung einen Ladezustand der Energiespeicherzellen zu ermitteln und die ordnungsgemäße Funktion der Mess-Schaltmittel zu überwachen.

Die Steuereinheit und die Messeinheit können beispielsweise gemeinsam durch eine Mikroprozessorapplikation realisiert sein.

In einer Ausführungsform ist die Steuereinheit dazu ausgebildet, zum Überwachen der ordnungsgemäßen Funktion der Mess-Schaltmittel die Mess-Schaltmittel und das Symmetrier-Schaltmittel derart sequenziell anzusteuern, dass in einem zeitlichen Mittel aus jeder Energiespeicherzelle eine identische Ladungsmenge entnommen wird.

In einer Ausführungsform ist die Steuereinheit dazu ausgebildet, zum Ermitteln des Ladezustands der Energiespeicherzellen die Mess-Schaltmittel und das Symmetrier-Schaltmittel derart sequenziell anzusteuern, dass in einem zeitlichen Mittel aus jeder Energiespeicherzelle eine identische Ladungsmenge entnommen wird.

In einer Ausführungsform ist die Steuereinheit dazu ausgebildet, zum Überwachen der ordnungsgemäßen Funktion der Mess-Schaltmittel in einer Überwachungs-Sequenz das Symmetrier-Schaltmittel zu schließen und in aufeinanderfolgenden Schritten immer nur eines der Mess-Schaltmittel zu schließen, bis alle Mess-Schaltmittel einmal geschlossen worden sind, und in einer Kompensations-Sequenz bei zunächst geschlossenem Symmetrier-Schaltmittel das erste Mess-Schaltmittel zu schließen, danach das Symmetrier-Schaltmittel zu öffnen und in aufeinanderfolgenden Schritten immer nur eines der weiteren Mess-Schaltmittel zu schließen, bis alle weiteren Mess-Schaltmittel einmal geschlossen worden sind, wobei die Überwachungs-Sequenz und die Kompensations-Sequenz gleich häufig durchgeführt werden.

Die Erfindung wird nachfolgend unter Bezugnahme auf die Zeichnungen detailliert beschrieben. Hierbei zeigt:
- Fig. 1: ein schematisches Schaltbild eines elektrischen Energiespeichers,
- Fig. 2a/j: einen Messzyklus zum Ermitteln eines Ladezustands von Energiespeicherzellen des in Fig. 1 gezeigten elektrischen Energiespeichers,
- Fig. 3a/j: eine Überwachungs-Sequenz zum Überwachen der ordnungsgemäßen Funktion von Mess-Schaltmitteln des in Fig. 1 gezeigten elektrischen Energiespeichers, und
- Fig. 4a/j: eine Kompensations-Sequenz zum Kompensieren der durch die Überwachungs-Sequenz verursachten asymmetrischen Entladung der Energiespeicherzellen.

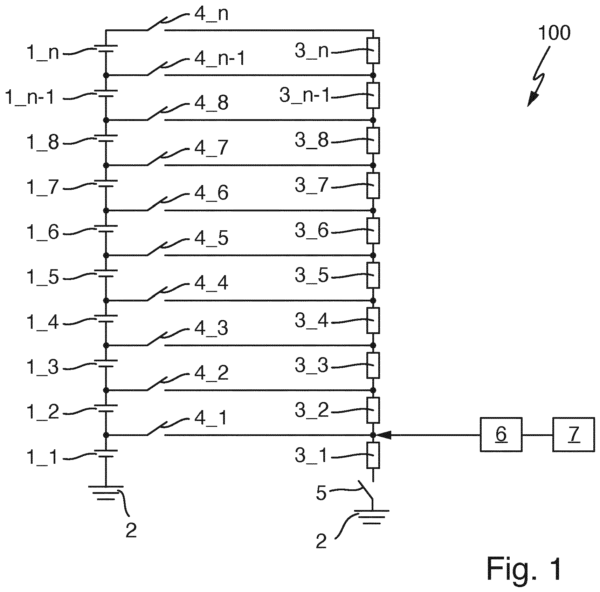

Fig. 1 zeigt ein schematisches Schaltbild eines elektrischen Energiespeichers 100. Der elektrische Energiespeicher 100 weist auf: eine Reihenschaltung einer Anzahl n von Energiespeicherzellen 1_1, ..., 1_n, wobei eine Energiespeicherzelle 1_1 mit einem Bezugspotential 2 verbunden ist.

Der elektrische Energiespeicher 100 weist weiter eine Reihenschaltung einer Anzahl n von Messwiderständen 3_1, ..., 3_n mit identischen Widerstandswerten auf.

Der elektrische Energiespeicher 100 weist weiter eine Anzahl n von Mess-Schaltmitteln 4_1, ..., 4_n auf, wobei zwischen die Reihenschaltung der Anzahl n von Energiespeicherzellen 1_1, ..., 1_n und die Reihenschaltung der Anzahl n von Messwiderständen 3_1, ..., 3_n ein erstes Mess-Schaltmittel 4_n eingeschleift ist und wobei zwischen Verbindungsknoten von benachbarten Energiespeicherzellen 1_1, ..., 1_n und Verbindungsnoten von benachbarten Messwiderständen 3_1, ..., 3_n ein jeweils zugehöriges Mess-Schaltmittel 4_1, ..., 4_n-1 eingeschleift ist.

Der elektrische Energiespeicher 100 weist weiter ein Symmetrier-Schaltmittel 5 auf, das zwischen einen Messwiderstand 3_1 und das Bezugspotential 2 eingeschleift ist.

Der elektrische Energiespeicher 100 weist weiter eine Messeinheit 6 auf, die eine an dem Messwiderstand 3_1 abfallende Spannung misst.

Der elektrische Energiespeicher 100 weist weiter eine Steuereinheit 7 auf, die dazu ausgebildet ist, die Mess-Schaltmittel 4_1, ..., 4_n und das Symmetrier-Schaltmittel 5 anzusteuern, in Abhängigkeit von einem Schaltzustand der Mess-Schaltmittel 4_1, ..., 4_n und des Symmetrier-Schaltmittels 5 und der mittels der Messeinheit 6 gemessenen Spannung einen Ladezustand der Energiespeicherzellen 1_1, ..., 1_n zu ermitteln und die ordnungsgemäße Funktion der Mess-Schaltmittel 4_1, ..., 4_n zu überwachen.

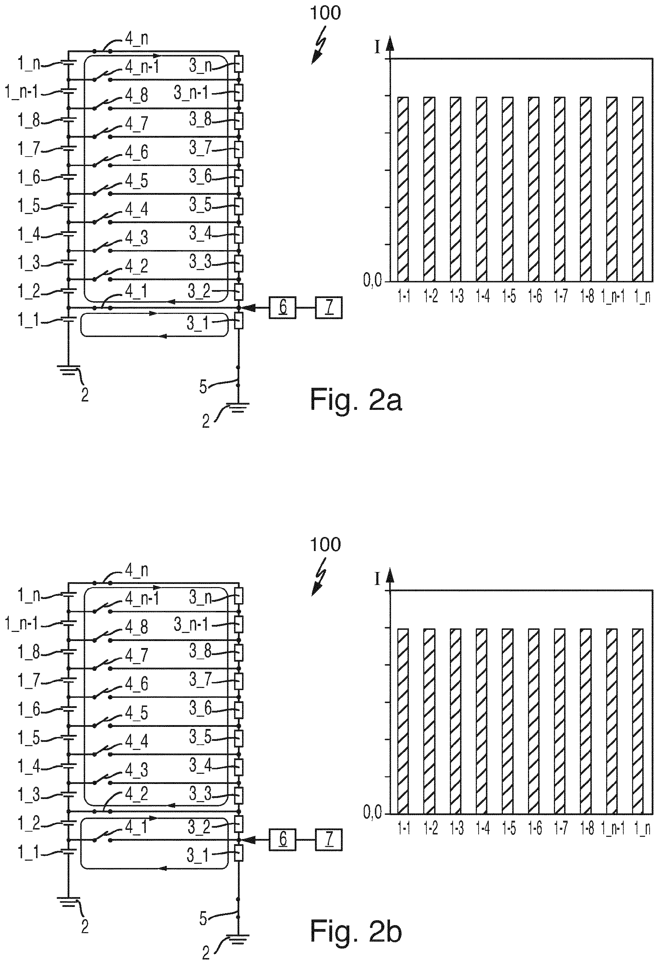

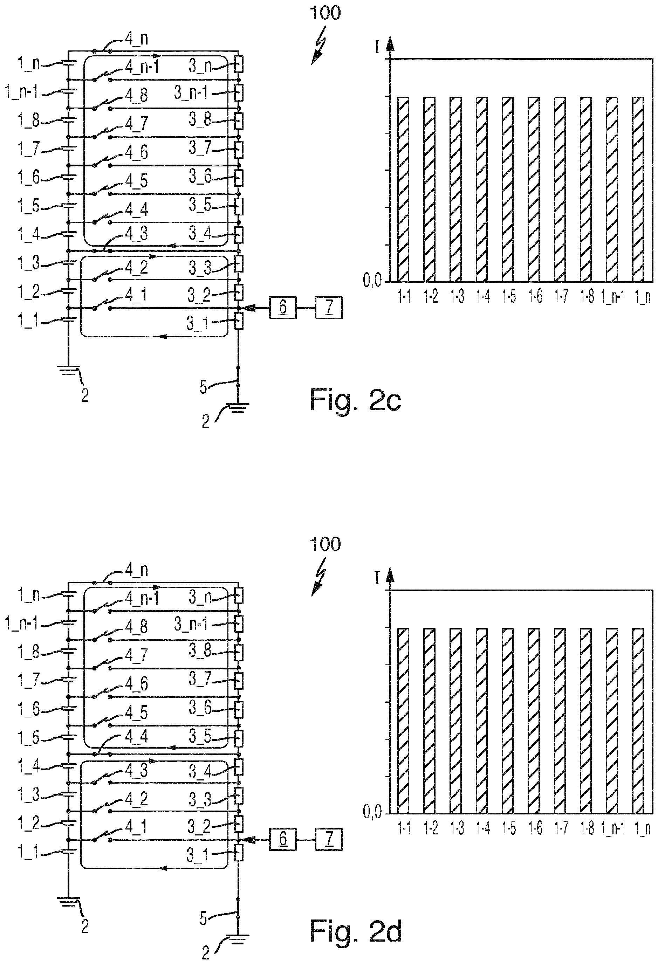

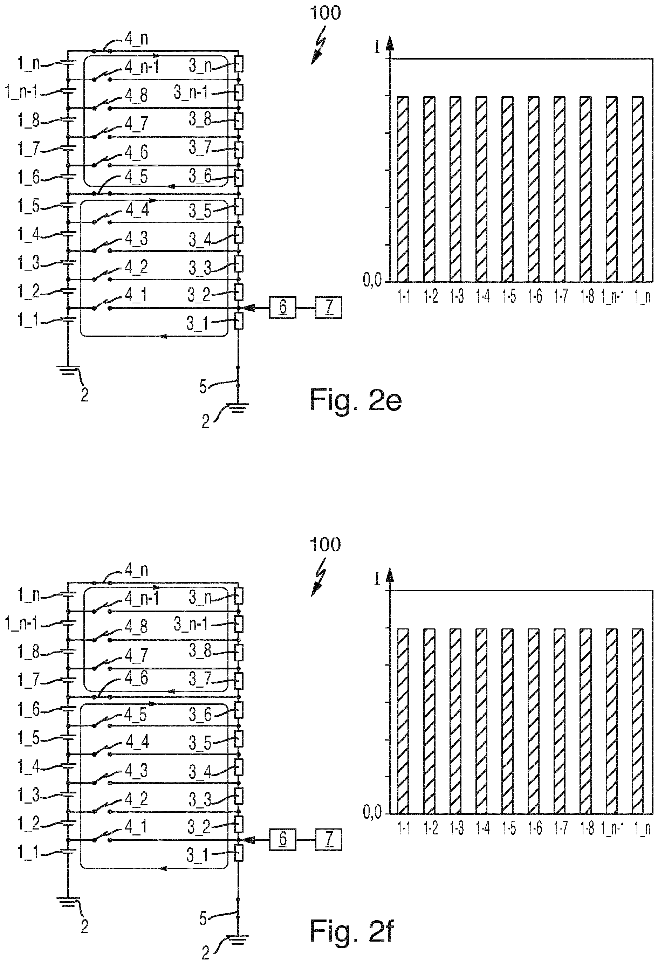

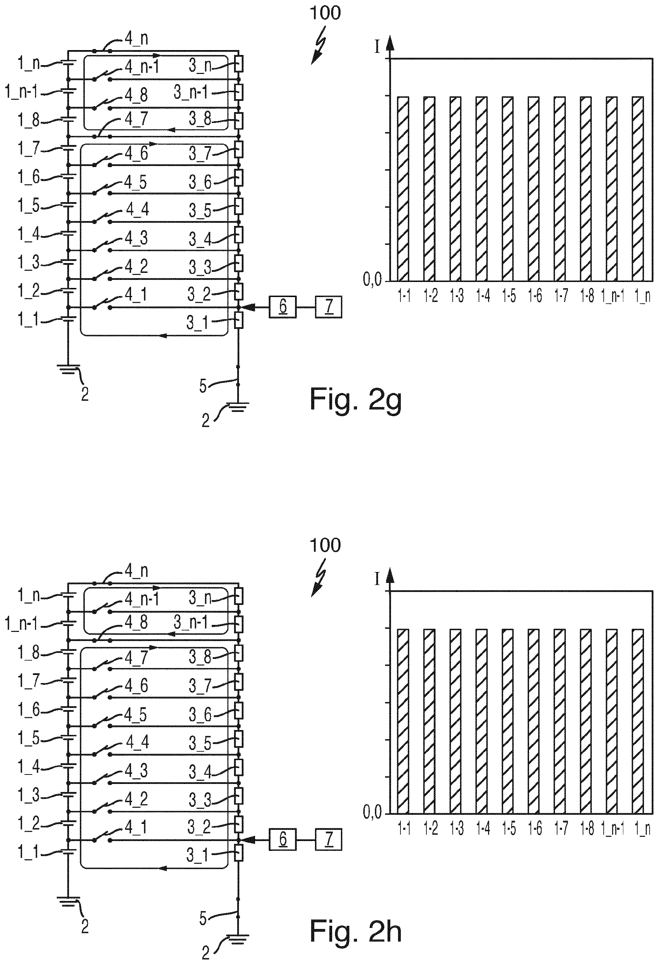

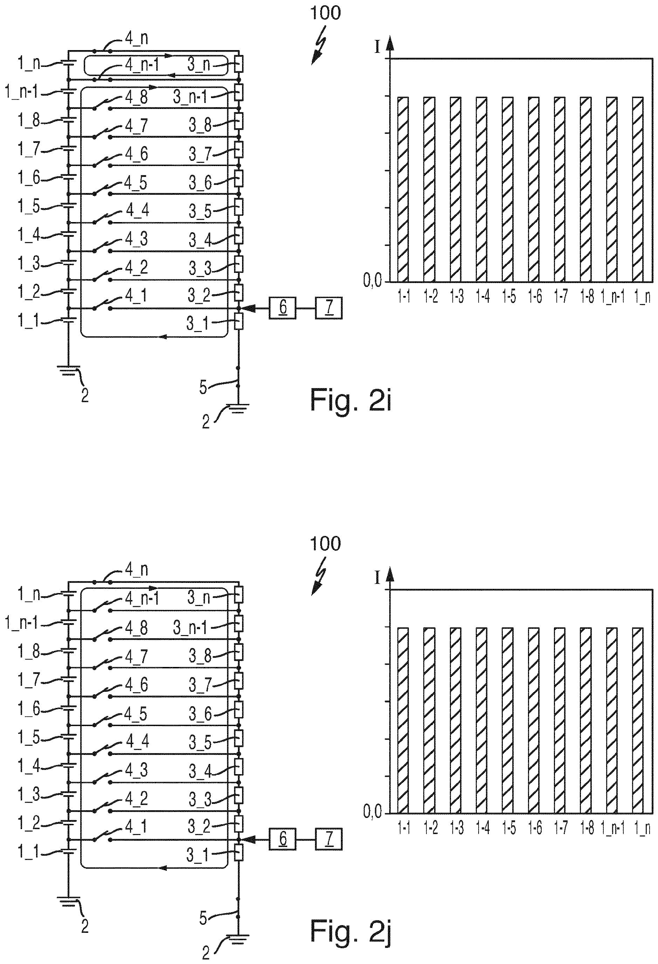

Die Fig. 2a/j zeigen exemplarisch einen Messzyklus zum Ermitteln des Ladezustands der Energiespeicherzellen 1_1, ..., 1_n. Im Messzyklus bleiben das erste bzw. obere Mess-Schaltmittel 4_n und das Symmetrier-Schaltmittel 5 dauerhaft geschlossen. Rechts ist jeweils der Strombeitrag der jeweiligen Energiespeicherzellen 1_1, ..., 1_n dargestellt.

Fig. 2a zeigt schematisch einen ersten Schritt des Messzyklus. Hierbei ist das Mess-Schaltmittel 4_1 geschlossen und die Mess-Schaltmittel 4_2 bis 4_n-1 sind geöffnet. Basierend auf der am Mess-Widerstand 3_1 gemessenen Spannung wird der Ladezustand der Energiespeicherzelle 1_1 ermittelt.

Fig. 2b zeigt schematisch einen zweiten Schritt des Messzyklus. Hierbei ist das Mess-Schaltmittel 4_2 geschlossen und die Mess-Schaltmittel 4_1 und 4_3 bis 4_n-1 sind geöffnet. Basierend auf der am Mess-Widerstand 3_1 gemessenen Spannung und der zuvor gemessenen Spannung wird der Ladezustand der Energiespeicherzelle 1_2 ermittelt.

Die Figuren 2c bis 2j zeigen nun die weiteren Schritte des Messzyklus.

Die Mess-Schaltmittel 4_1, ..., 4_n werden folglich derart sequenziell angesteuert, dass in einem zeitlichen Mittel aus jeder Energiespeicherzelle 1_1, ..., 1_n eine identische Ladungsmenge entnommen wird. Eine jeweilige Dauer der Schritte des Messzyklus ist hierbei identisch.

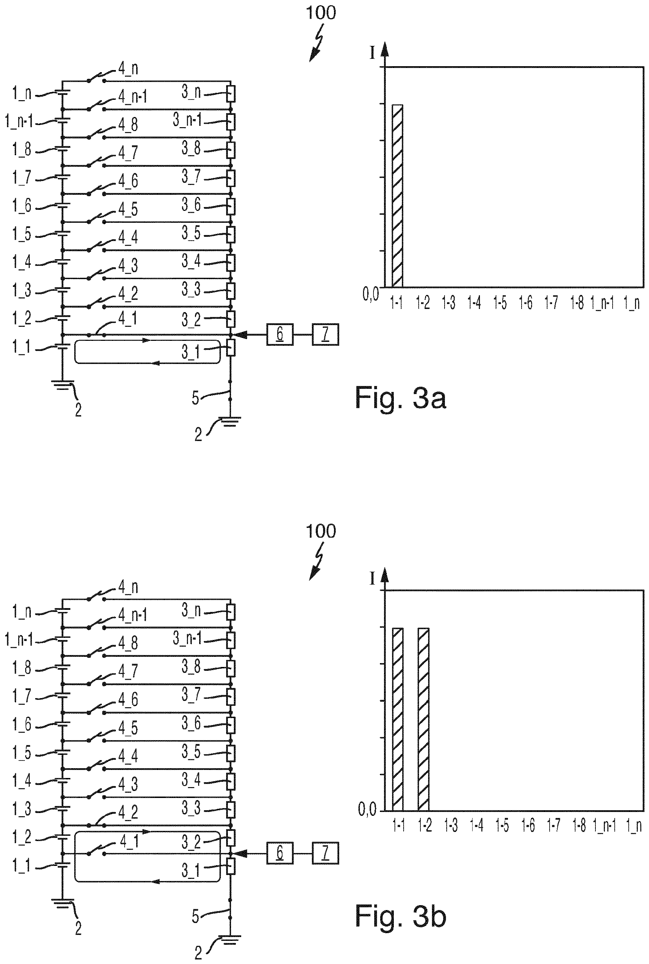

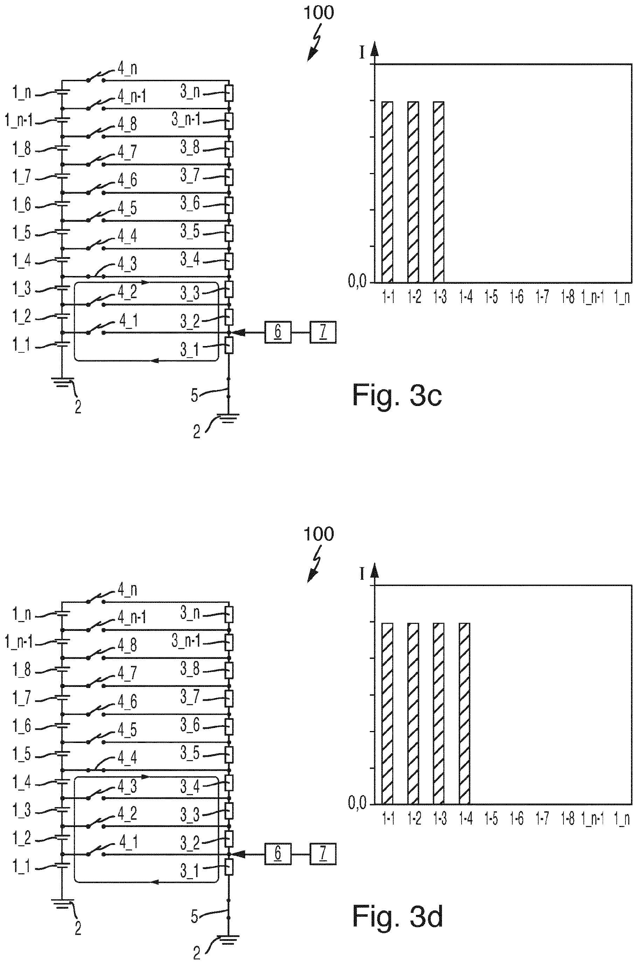

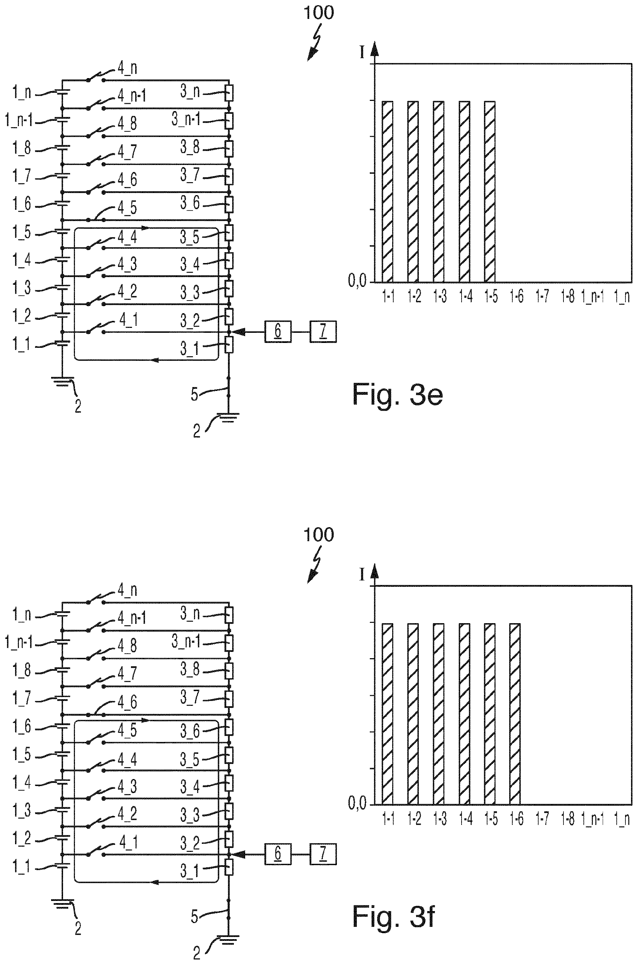

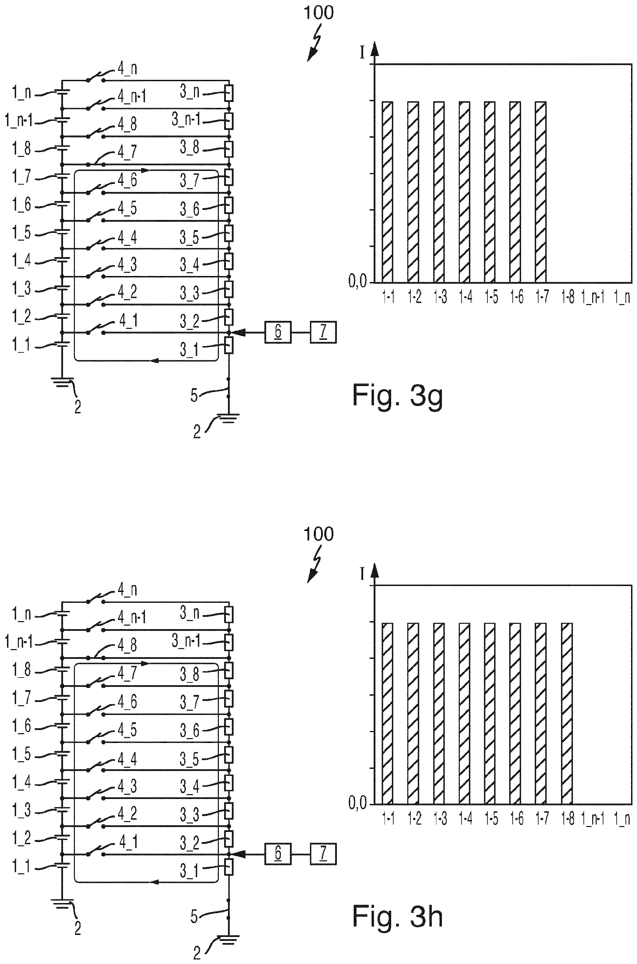

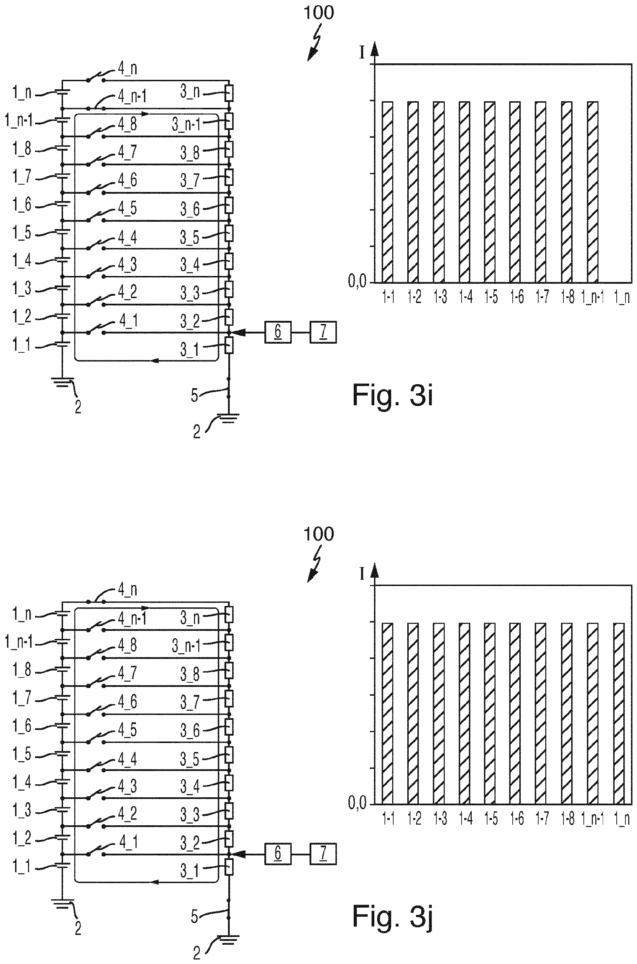

Die Fig. 3a/j zeigen schematisch eine Überwachungs-Sequenz zum Überwachen der ordnungsgemäßen Funktion der Mess-Schaltmittel 4_1 bis 4_n. Rechts ist jeweils der Strombeitrag der jeweiligen Energiespeicherzellen 1_1, ..., 1_n dargestellt. In der Überwachungs-Sequenz ist das Symmetrier-Schaltmittel 5 geschlossen und in aufeinanderfolgenden Schritten wird immer nur eines der Mess-Schaltmittel 4_1, ..., 4_n-1 geschlossen, so lange bis alle Mess-Schaltmittel 4_1, ..., 4_n-1 einmal geschlossen worden sind. Anhand der am Mess-Widerstand 3_1 gemessenen Spannung kann die korrekte Funktion der Mess-Schaltmittel 4_1, ..., 4_n überprüft werden.

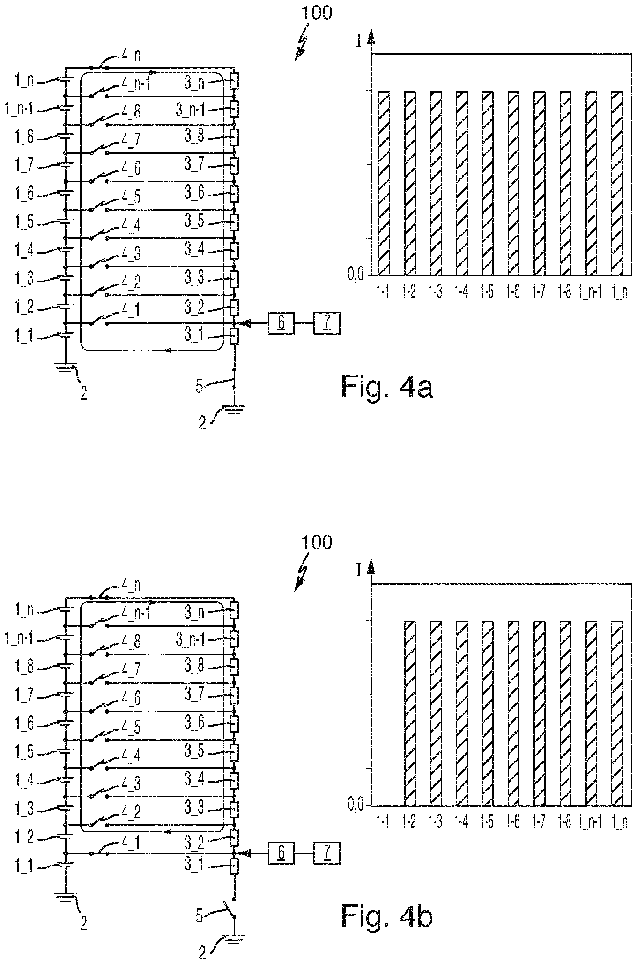

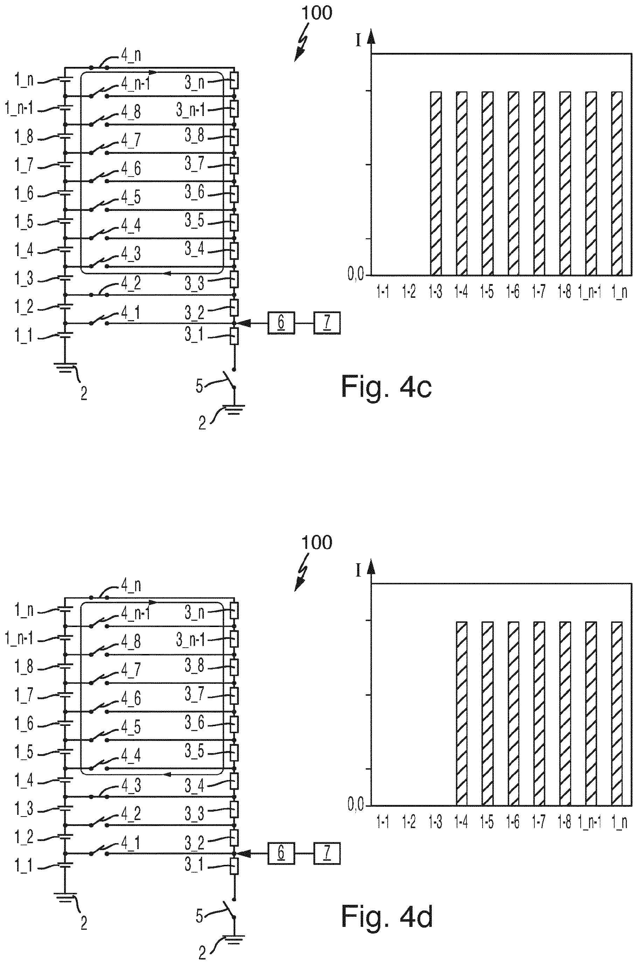

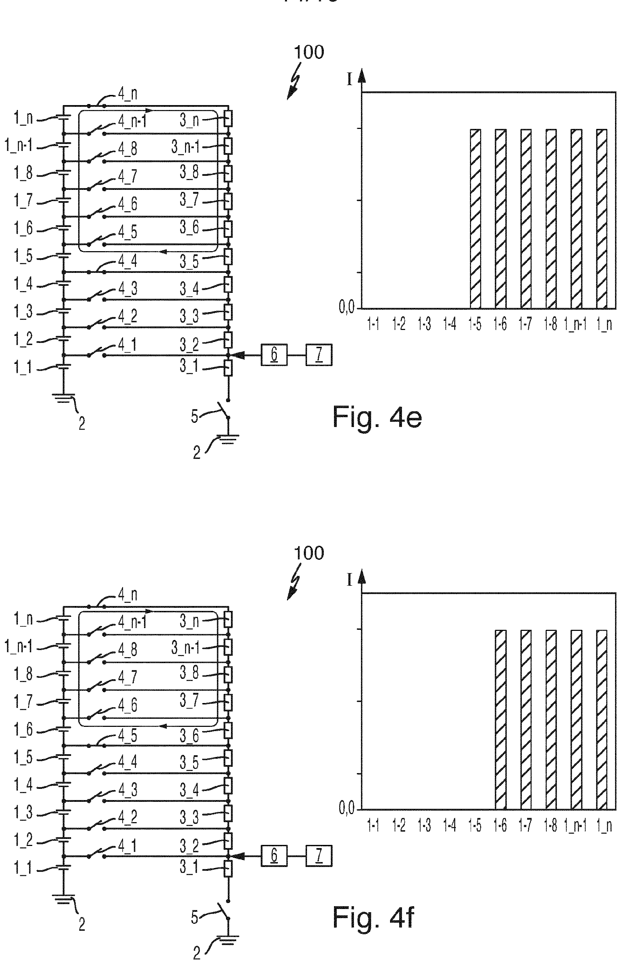

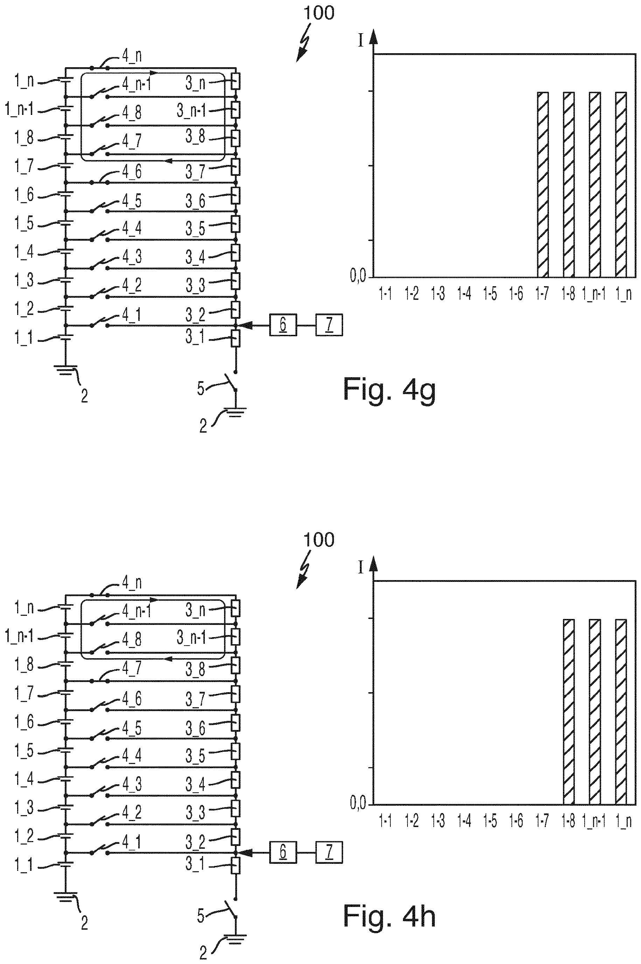

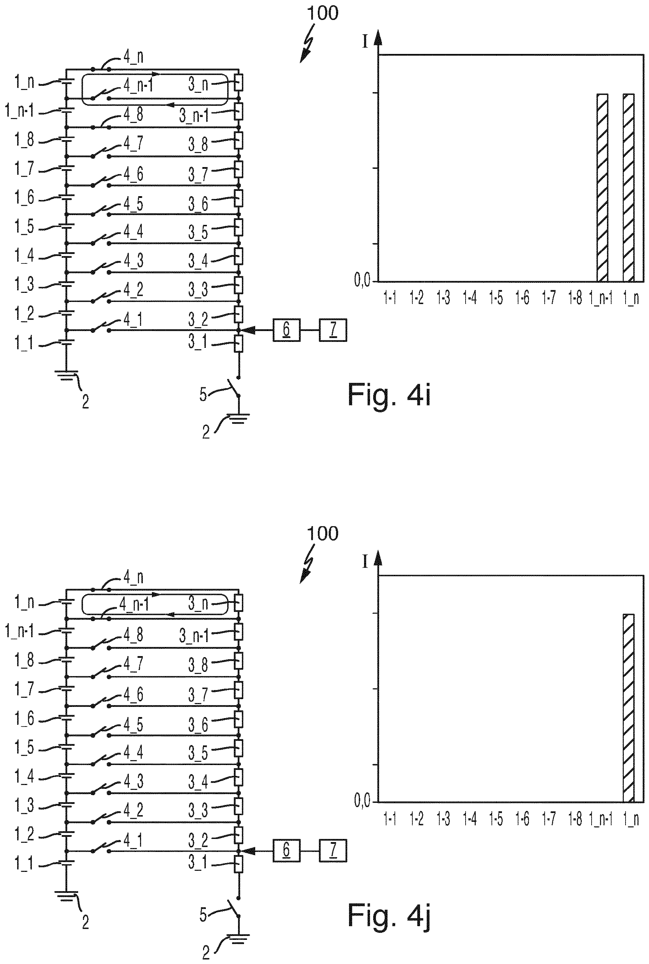

Die Fig. 4a/j zeigen schematisch eine Kompensations-Sequenz zum Kompensieren der durch die Überwachungs-Sequenz verursachten asymmetrischen Entladung der Energiespeicherzellen 1_1, ..., 1_n. Rechts ist jeweils der Strombeitrag der jeweiligen Energiespeicherzellen 1_1, ..., 1_n dargestellt. In der Kompensations-Sequenz wird zunächst, wie in Fig. 4a gezeigt, bei geschlossenem Symmetrier-Schaltmittel 5 das erste Mess-Schaltmittel 4_n geschlossen.

Bezug nehmend auf die Figuren 4b/j wird danach das Symmetrier-Schaltmittel 5 dauerhaft geöffnet und in aufeinanderfolgenden Schritten immer nur eines der weiteren Mess-Schaltmittel 4_1, ..., 4_n-1 geschlossen, so lange bis alle weiteren Mess-Schaltmittel 4_1, ..., 4_n-1 einmal geschlossen worden sind. Anhand der am Mess-Widerstand 3_1 gemessenen Spannung kann die korrekte Funktion der Mess-Schaltmittel 4_1, ..., 4_n überprüft werden.

Die Überwachungs-Sequenz und die Kompensations-Sequenz werden gleich häufig durchgeführt, so dass in einem zeitlichen Mittel aus jeder Energiespeicherzelle 1_1, ..., 1_n eine identische Ladungsmenge entnommen wird.

Eine jeweilige Dauer der Schritte der Überwachungs-Sequenz ist hierbei identisch und eine jeweilige Dauer der Schritte der Kompensations-Sequenz ist hierbei ebenfalls identisch.

## Patentansprüche

1. Elektrischer Energiespeicher (100), insbesondere für ein handgetragenes Elektrowerkzeug, aufweisend:
- eine Reihenschaltung einer Anzahl n von Energiespeicherzellen (1_1, ..., 1_n), wobei eine Energiespeicherzelle (1_1) der Energiespeicherzellen (1_1, ..., 1_n) mit einem Bezugspotential (2) verbunden ist,
- eine Reihenschaltung einer Anzahl n von Messwiderständen (3_1, ..., 3_n),
- eine Anzahl n von Mess-Schaltmitteln (4_1, ..., 4_n),
- wobei zwischen die Reihenschaltung der Anzahl n von Energiespeicherzellen (1_1, ..., 1_n) und die Reihenschaltung der Anzahl n von Messwiderständen (3_1, ..., 3_n) ein erstes Mess-Schaltmittel (4_n) der Anzahl n von Mess-Schaltmitteln (4_1, ..., 4_n) eingeschleift ist, und
- wobei zwischen Verbindungsknoten von benachbarten Energiespeicherzellen (1_1, ..., 1_n) und Verbindungsnoten von benachbarten Messwiderständen (3_1, ..., 3_n) ein zugehöriges Mess-Schaltmittel (4_1, ..., 4_n-1) eingeschleift ist,
- ein Symmetrier-Schaltmittel (5), das zwischen einen Messwiderstand (3_1) der Anzahl n von Messwiderständen (3_1, ..., 3_n) und das Bezugspotential (2) eingeschleift ist,
- eine Messeinheit (6), die eine an einem Messwiderstand (3_1) der Anzahl n von Messwiderständen (3_1, ..., 3_n) abfallende Spannung misst,
**gekennzeichnet durch**
- eine Steuereinheit (7), die dazu ausgebildet ist, die Mess-Schaltmittel (4_1, ..., 4_n) und das Symmetrier-Schaltmittel (5) anzusteuern, in Abhängigkeit von einem Schaltzustand der Mess-Schaltmittel (4_1, ..., 4_n) und des Symmetrier-Schaltmittels (5) und der mittels der Messeinheit (6) gemessenen Spannung einen Ladezustand der Energiespeicherzellen (1_1, ..., 1_n) zu ermitteln und die ordnungsgemäße Funktion der Mess-Schaltmittel (4_1, ..., 4_n) zu überwachen.

2. Elektrischer Energiespeicher (100) nach Anspruch 1, **dadurch gekennzeichnet, dass**
- die Steuereinheit (7) dazu ausgebildet ist, zum Überwachen der ordnungsgemäßen Funktion der Mess-Schaltmittel (4_1, ..., 4_n) die Mess-Schaltmittel (4_1, ..., 4_n) und das Symmetrier-Schaltmittel (5) derart sequenziell anzusteuern, dass in einem zeitlichen Mittel aus jeder Energiespeicherzelle (1_1, ..., 1_n) eine identische Ladungsmenge entnommen wird.

3. Elektrischer Energiespeicher (100) nach Anspruch 1 oder 2, **dadurch gekennzeichnet, dass**
- die Steuereinheit (7) dazu ausgebildet ist, zum Ermitteln des Ladezustands der Energiespeicherzellen (1_1, ..., 1_n) die Mess-Schaltmittel (4_1, ..., 4_n) und das Symmetrier-Schaltmittel (5) derart sequenziell anzusteuern, dass in einem zeitlichen Mittel aus jeder Energiespeicherzelle (1_1, ..., 1_n) eine identische Ladungsmenge entnommen wird.

4. Elektrischer Energiespeicher (100) nach einem der vorhergehenden Ansprüche, **dadurch gekennzeichnet, dass**
- die Steuereinheit (7) dazu ausgebildet ist, zum Überwachen der ordnungsgemäßen Funktion der Mess-Schaltmittel (4_1, ..., 4_n)
- in einer Überwachungs-Sequenz das Symmetrier-Schaltmittel (5) zu schließen und in aufeinanderfolgenden Schritten immer nur eines der Mess-Schaltmittel (4_1, ..., 4_n-1) zu schließen, bis alle Mess-Schaltmittel (4_1, ..., 4_n-1) einmal geschlossen worden sind, und
- in einer Kompensations-Sequenz bei geschlossenem Symmetrier-Schaltmittel (5) das erste Mess-Schaltmittel (4_n) zu schließen, danach das Symmetrier-Schaltmittel (5) zu öffnen und in aufeinanderfolgenden Schritten immer nur eines der weiteren Mess-Schaltmittel (4_1, ..., 4_n-1) zu schließen, bis alle weiteren Mess-Schaltmittel (4_1, ..., 4_n-1) einmal geschlossen worden sind,
- wobei die Überwachungs-Sequenz und die Kompensations-Sequenz gleich häufig durchgeführt werden.

## Claims

1. Electrical energy store (100), in particular for a handheld power tool, having:
- a series connection of a number n of energy storage cells (1_1, ..., 1_n), wherein one energy storage cell (1_1) of the energy storage cells (1_1, ..., 1_n) is connected to a reference potential (2),
- a series connection of a number n of measuring resistors (3_1, ..., 3_n),
- a number n of measuring switching means (4_1, ..., 4_n),
- wherein a first measuring switching means (4_n) of the number n of measuring switching means (4_1, ..., 4_n) is looped in between the series connection of the number n of energy storage cells (1_1, ..., 1_n) and the series connection of the number n of measuring resistors (3_1, ..., 3_n), and
- wherein a corresponding measuring switching means (4_1, ..., 4_n-1) is looped in between connection nodes of neighbouring energy storage cells (1_1, ..., 1_n) and connection nodes of neighbouring measuring resistors (3_1, ..., 3_n),
- a balancing switching means (5) which is looped in between a measuring resistor (3_1) of the number n of measuring resistors (3_1, ..., 3_n) and the reference potential (2),
- a measuring unit (6) which measures a voltage dropped across a measuring resistor (3_1) of the number n of measuring resistors (3_1, ..., 3_n),
**characterized by**
- a control unit (7) which is designed to control the measuring switching means (4_1, ..., 4_n) and the balancing switching means (5), to ascertain a state of charge of the energy storage cells (1_1, ..., 1_n) depending on a switching state of the measuring switching means (4_1, ..., 4_n) and of the balancing switching means (5) and on the voltage measured by means of the measuring unit (6), and to monitor the proper functioning of the measuring switching means (4_1, ..., 4_n).

2. Electrical energy store (100) according to Claim 1, **characterized in that**,
- in order to monitor the proper functioning of the measuring switching means (4_1, ..., 4_n), the control unit (7) is designed to control the measuring switching means (4_1, ..., 4_n) and the balancing switching means (5) sequentially in such a way that an identical amount of charge is drawn from each energy storage cell (1_1, ..., 1_n) on average over time.

3. Electrical energy store (100) according to Claim 1 or 2, **characterized in that**,
- in order to ascertain the state of charge of the energy storage cells (1_1, ..., 1_n), the control unit (7) is designed to control the measuring switching means (4_1, ..., 4_n) and the balancing switching means (5) sequentially in such a way that an identical amount of charge is drawn from each energy storage cell (1_1, ..., 1_n) on average over time.

4. Electrical energy store (100) according to one of the preceding claims, **characterized in that**,
- in order to monitor the proper functioning of the measuring switching means (4_1, ..., 4_n), the control unit (7) is designed,
- in a monitoring sequence, to close the balancing switching means (5) and to close always only one of the measuring switching means (4_1, ..., 4_n-1) in successive steps until all the measuring switching means (4_1, ...,
4_n-1) have been closed once, and,
- in a compensation sequence, with the balancing switching means (5) closed, to close the first measuring switching means (4_n), then to open the balancing switching means (5) and to close always only one of the further measuring switching means (4_1, ..., 4_n-1) in successive steps until all of the further measuring switching means (4_1, ..., 4_n-1) have been closed once,
- wherein the monitoring sequence and the compensation sequence are carried out equally frequently.

## Revendications

1. Accumulateur d'énergie électrique (100), en particulier pour un outil électrique portatif, présentant :
- un montage en série d'un nombre n de cellules d'accumulateur d'énergie (1_1, ..., 1_n), dans lequel une cellule d'accumulateur d'énergie (1_1) des cellules d'accumulateur d'énergie (1_1, ..., 1_n) est reliée à un potentiel de référence (2),
- un montage en série d'un nombre n de résistances de mesure (3_1, ..., 3_n),
- un nombre n de moyens de commutation de mesure (4_1, ..., 4_n),
- dans lequel un premier moyen de commutation de mesure (4_n) du nombre n de moyens de commutation de mesure (4_1, ..., 4_n) est mis dans la boucle entre le montage en série du nombre n de cellules d'accumulateur d'énergie (1_1, ..., 1_n) et le montage en série du nombre n de résistances de mesure (3_1, ..., 3_n), et
- dans lequel un moyen de commutation de mesure associé (4_1, ..., 4_n-1) est mis dans la boucle entre des noeuds de liaison de cellules d'accumulateur d'énergie voisines (1_1, ..., 1_n) et des noeuds de liaison de résistances de mesure voisines (3_1, ..., 3_n),
- un moyen de commutation d'équilibrage (5) qui est mis dans la boucle entre une résistance de mesure (3_1) du nombre n de résistances de mesure (3_1, ..., 3_n) et le potentiel de référence (2),
- une unité de mesure (6) qui mesure une tension chutant au niveau d'une résistance de mesure (3_1) du nombre n de résistances de mesure (3_1, ..., 3_n), **caractérisé par**
- une unité de commande (7) qui est réalisée pour piloter les moyens de commutation de mesure (4_1, ..., 4_n) et le moyen de commutation d'équilibrage (5), pour établir en fonction d'un état de commutation des moyens de commutation de mesure (4_1, ..., 4_n) et du moyen de commutation d'équilibrage (5) et de la tension mesurée au moyen de l'unité de mesure un état de charge des cellules d'accumulateur d'énergie (1_1, ..., 1_n), et pour surveiller le fonctionnement correct des moyens de commutation de mesure (4_1, ..., 4_n).

2. Accumulateur d'énergie électrique (100) selon la revendication 1, **caractérisé en ce que**
- pour la surveillance du fonctionnement correct des moyens de commutation de mesure (4_1, ..., 4_n), l'unité de commande (7) est réalisée pour piloter les moyens de commutation de mesure (4_1, ..., 4_n) et le moyen de commutation d'équilibrage (5) en séquence de telle sorte qu'une quantité de charge identique soit prélevée sur chaque cellule d'accumulateur d'énergie (1_1, ..., 1_n) dans une moyenne temporelle.

3. Accumulateur d'énergie électrique (100) selon la revendication 1 ou 2, **caractérisé en ce que**
- pour l'établissement de l'état de charge des cellules d'accumulateur d'énergie (1_1, ..., 1_n), l'unité de commande (7) est réalisée pour piloter les moyens de commutation de mesure (4_1, ..., 4_n) et le moyen de commutation d'équilibrage (5) en séquence de telle sorte qu'une quantité de charge identique soit prélevée sur chaque cellule d'accumulateur d'énergie (1_1, ..., 1_n) dans une moyenne temporelle.

4. Accumulateur d'énergie électrique (100) selon l'une quelconque des revendications précédentes, **caractérisé en ce que**
- l'unité de commande (7) est réalisée pour surveiller le fonctionnement correct des moyens de commutation de mesure (4_1, ..., 4_n),
- pour fermer le moyen de commutation d'équilibrage (5) dans une séquence de surveillance, et pour fermer dans des étapes consécutives un seul des moyens de commutation de mesure (4_1, ..., 4_n-1) respectivement jusqu'à ce que tous les moyens de commutation de mesure (4_1, ..., 4_n-1) aient été fermés une fois, et
- dans une séquence de compensation, lorsque le moyen de commutation d'équilibrage (5) est fermé, pour fermer le premier moyen de commutation (4_n), ensuite pour ouvrir le moyen de commutation d'équilibrage (4), et dans des étapes consécutives pour fermer un seul des moyens de commutation de mesure supplémentaires (4_1, ..., 4_n-1) respectivement jusqu'à ce que tous les moyens de commutation de mesure supplémentaires (4_1, ..., 4_n-1) aient été fermés une fois,
- dans lequel la séquence de surveillance et la séquence de compensation sont effectuées avec la même fréquence.
